# EUROPEAN PATENT APPLICATION

(11) **EP 4 711 489 A1**
(43) Date of publication of application: **18.03.2026**
(21) Application number: 24794320.2
(22) Date of filing: 26.04.2024
(51) Int. Cl.: C23C 14/20, C23C 14/34, C23C 14/22, C23C 14/02, H05K 3/16, H01J 37/34, H10K 71/16, H10K 50/10

(54) **METHOD FOR MANUFACTURING FLEXIBLE COPPER CLAD LAMINATE HAVING PTFE SUBSTRATE**

(30) Priority: 08.05.2023 KR 20230059403; 22.04.2024 KR 20240053128
(71) Applicant: CIT Co., Ltd., Busan 46285 (KR)
(72) Inventor: JEONG, Seung, Seoul 08725 (KR); JEONG, Se Young, Busan 48119 (KR); LEE, You Sil, Busan 47756 (KR)
(74) Representative: advotec.
(86) International application number: PCT/KR2024/005684
(87) International publication number: WO 2024/232574

(57) **Abstract**

The present invention relates to a method of manufacturing a flexible copper clad laminated film having a polytetrafluoroethylene (PTFE) substrate. More specifically, the present invention relates to a method of manufacturing a flexible copper clad laminated (FCCL) film having a polytetrafluoroethylene (PTFE) substrate, in which a metal thin film is uniformly deposited on the polytetrafluoroethylene (PTFE) substrate to manufacture a flexible copper clad laminated (FCCL) film, which can improve the electrical performance of the flexible copper clad laminated film and avoid the property degradation of the polytetrafluoroethylene (PTFE) substrate.

## Description

### [Technical Field]

The present invention relates to a method of manufacturing a flexible copper clad laminated film having a polytetrafluoroethylene (PTFE) substrate. More specifically, the present invention relates to a method of manufacturing a flexible copper clad laminated (FCCL) film having a polytetrafluoroethylene (PTFE) substrate, in which a metal thin film is uniformly deposited on the polytetrafluoroethylene (PTFE) substrate to manufacture a flexible copper clad laminated (FCCL) film, which can improve the electrical performance of the flexible copper clad laminated film and avoid the property degradation of the polytetrafluoroethylene (PTFE) substrate.

### [Background Art]

The flexible copper clad laminated (FCCL) film is a core material of a flexible printed circuit board (FPCB), which is mainly used in smartphones, PCs, semiconductors, vehicle electronics, displays, mobility, secondary batteries, and the like. In general, the flexible copper clad laminated (FCCL) film is a product in which a metal thin film is laminated on both surfaces or one surface of a polymer substrate.

Various insulating materials such as a polyimide (PI) resin, a thermoplastic resin, a glass, an epoxy resin and a liquid crystalline polymer (LCP) may be applied as a substrate constituting the flexible copper clad laminated (FCCL) film, but preferably a polytetrafluoroethylene (PTFE) having excellent mechanical properties and electrical performance may be applied.

The polytetrafluoroethylene (PTFE) material has excellent mechanical properties such as chemical resistance, heat resistance, and dimensional stability, and has a low permittivity and dielectric loss compared to other insulating materials. Therefore, when applied to a printed circuit board (PCB) substrate, the polytetrafluoroethylene (PTFE) has an advantage of speeding up signal and data transmission in the same antenna circuit. In contrast, the polytetrafluoroethylene (PTFE) has poor metal adhesion compared to other insulating materials, and thus a method is required to enhance the adhesion between the polytetrafluoroethylene (PTFE) substrate and a metal.

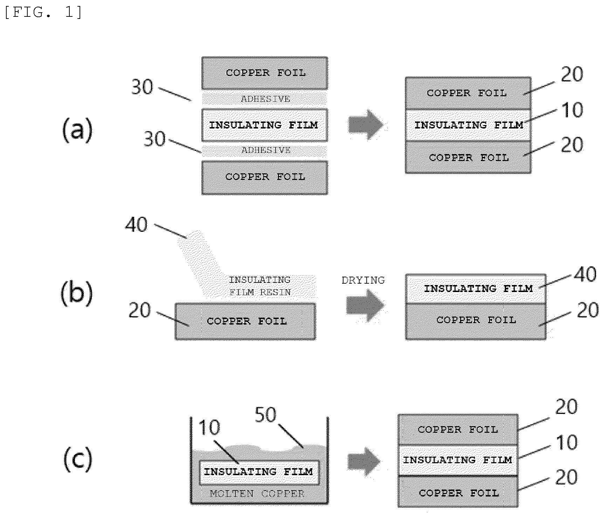

FIG. 1 illustrates various methods of manufacturing a flexible copper clad laminated (FCCL) film in the related art.

Among various methods of manufacturing a flexible copper clad laminated (FCCL) film for adhering a substrate and a copper thin film in manufacturing the flexible copper clad laminated (FCCL) film, a laminating process illustrated in FIG. 1A is a method of applying an adhesive 30 to one surface or both surfaces of a polytetrafluoroethylene (PTFE) substrate 10 to adhere a copper thin film 20, a casting process illustrated in FIG. 1B is a method of casting a solution of an insulating resin 40 that is a mixture of polyimide (PI) and polytetrafluoroethylene (PTFE) onto the copper thin film 20 to adhere the copper thin film 20 to a substrate formed of the insulating resin 40, and a coating process illustrated in FIG. 1C is a method of impregnating the polyimide (PI) into the polytetrafluoroethylene (PTFE) substrate 10 and then plating or coating a copper melt solution 50 on the impregnated polytetrafluoroethylene (PTFE) substrate 10 to adhere the copper thin film 20.

As illustrated in FIG. 1, since the method of manufacturing a flexible copper clad laminated (FCCL) film in the related art uses an adhesive or polyimide (PI), there was a problem in that the permittivity of the flexible copper clad laminated (FCCL) film increases compared to the case of using the polytetrafluoroethylene (PTFE) substrate 10 alone, slowing down the signal and data transmission speed.

Accordingly, a sputtering process has been proposed in which a copper thin film is directly deposited on the polytetrafluoroethylene (PTFE) substrate 10, which may prevent problems such as slowing down the transmission speed of the flexible copper clad laminated (FCCL) film due to the use of an adhesive or PI as in the related art.

The sputtering process is a type of vacuum deposition method mainly used in the production of integrated circuits, which involves a process of accelerating gas ions ionized at a relatively low vacuum degree to collide with a target and eject atoms to then form a thin film on a substrate. It is important to control this sputtering process to ensure uniform deposition of metal particles forming a thin film on the substrate to eliminate electrical noise or physical vibration.

Among related art, Korean Patent Publication No. 10-2022-0049366 discloses a sputtering apparatus for controlling particles coming from a target by atomic layer units to evenly grow a metal thin film on a substrate.

Meanwhile, as a result of forming a metal thin film on a substrate to which various materials were applied using the sputtering apparatus according to the related art as described above, a metal thin film was uniformly formed on a substrate having a crystalline structure such as sapphire (aluminum oxide), but a metal thin film could not be uniformly formed on a substrate made of a polytetrafluoroethylene (PTFE) due to difficulty in controlling the atomic layer, and the properties of the polytetrafluoroethylene (PTFE) substrate were damaged or deformed during the deposition process, resulting in a problem of degrading the quality of the flexible copper clad laminated (FCCL) film.

Recently, with the development of high-tech industries such as communications, displays, semiconductors, and secondary batteries, the demand for flexible copper clad laminated (FCCL) films has been increasing rapidly, but there are almost no technologies that may uniformly deposit a metal thin film on a polytetrafluoroethylene (PTFE) substrate, which is widely applied as a substrate material for the FCCL.
Therefore, there is an acute need for a method of manufacturing a flexible copper clad laminated (FCCL) film having a polytetrafluoroethylene (PTFE) substrate which is capable of uniformly depositing a metal thin film on the polytetrafluoroethylene (PTFE) substrate while omitting the use of an adhesive or a resin such as polyimide (PI) as in the related art for manufacturing the flexible copper clad laminated (FCCL) film, thereby improving the electrical performance of the flexible copper clad laminated (FCCL) film and avoiding the property degradation of the polytetrafluoroethylene (PTFE) substrate.

### [Disclosure]

### [Technical Problem]

The present invention is directed to providing a method of manufacturing a flexible copper clad laminated (FCCL) film having a polytetrafluoroethylene (PTFE) substrate, in which a metal thin film is uniformly deposited on the polytetrafluoroethylene (PTFE) substrate to manufacture a flexible copper clad laminated (FCCL) film, which can improve the electrical performance of the flexible copper clad laminated film (FCCL) and avoid the property degradation of the polytetrafluoroethylene (PTFE) substrate.

### [Technical Solution]

To solve the aforementioned objects, the present invention is directed to providing a method of manufacturing a polytetrafluoroethylene (PTFE)-based flexible copper clad laminated substrate. The method may include: a polytetrafluoroethylene (PTFE) substrate preparation step, in which a substrate made of a polytetrafluoroethylene (PTFE) material is prepared in a chamber space of a vacuum chamber; a reaction gas injection step, in which a reaction gas is injected after the chamber space of the vacuum chamber is formed with a vacuum for a sputtering process; a high frequency power application step, in which high frequency power is applied to a target mounted on an inner upper portion of the vacuum chamber and made of single crystal metal particles; and a metal thin film lamination step, in which metal particles separated from the target by the applied high frequency power are deposited on top of the polytetrafluoroethylene (PTFE) substrate to form a metal thin film.

In addition, in the polytetrafluoroethylene (PTFE) substrate preparation step, the chamber space of the vacuum chamber in which the polytetrafluoroethylene (PTFE) substrate is prepared may be formed to have a temperature in a range of 140 °C to 200 °C.

Further, in the reaction gas injection step, the gas injected into the chamber space of the vacuum chamber may include argon (Ar).

In this case, in the high frequency power application step, the high frequency power may be transmitted to the target mounted on an inner upper end of the vacuum chamber through a power supply line constituted of a single crystal copper wire.

In this case, in the metal thin film lamination step, the metal thin film may be deposited on the top of the polytetrafluoroethylene (PTFE) substrate through an atomic sputtering epitaxy (ASE) process in which metal particles of atomic units are deposited on the top of the polytetrafluoroethylene (PTFE) substrate.

In addition, in the metal thin film lamination step, the metal thin film may be laminated on the top of the polytetrafluoroethylene (PTFE) substrate with a thickness in a range of 100 to 300 nm.

Further, in the metal thin film lamination step, the metal particles may include copper (Cu).

Here, in the metal thin film lamination step, vibrations transmitted to the vacuum chamber may be absorbed or blocked while the metal particles separated from the target are deposited on the top of the polytetrafluoroethylene (PTFE) substrate.

In addition, the method may further include: a metal thin film pattern formation step, in which a pattern having a specific shape is formed on a surface of the metal thin film that has been completed to be laminated on the top of the polytetrafluoroethylene (PTFE) substrate.

Further, the pattern formed in the metal thin film pattern formation step may have a hexagonal honeycomb shape with a linewidth of 5 µm to 14 µm.

### [Advantageous Effects]

According to a method of manufacturing a flexible copper clad laminated film having a polytetrafluoroethylene (PTFE) substrate according to the present invention, the adhesion between a polytetrafluoroethylene (PTFE) substrate and a metal thin film is improved using an atomic sputtering epitaxy (ASE) process, and the metal thin film is uniformly deposited on the polytetrafluoroethylene (PTFE) substrate, thereby improving the electrical performance of the flexible copper clad laminated film, which has excellent heat resistance and mechanical properties, and is applicable as an advanced material used in various industrial fields such as communications, semiconductors, displays, and secondary batteries.

### [Description of Drawings]

FIG. 1 illustrates various methods of manufacturing a flexible copper clad laminated (FCCL) film in the related art.
FIG. 2 illustrates an initial growth mechanism of a metal thin film deposited on a sapphire substrate through an atomic sputtering epitaxy (ASE) process.
FIG. 3 is a flowchart of a method of manufacturing a flexible copper clad laminated film having a polytetrafluoroethylene (PTFE) substrate according to the present invention.
FIG. 4 is an image observed using a scanning electron microscope (SEM) of each polytetrafluoroethylene (PTFE) substrate before and after copper deposition.
FIG. 5 is an image of a copper surface deposited on the PTFE observed using electron beam scatter diffraction (EBSD).
FIG. 6 is a photographing image of a mesh and a circuit patterned from a copper thin film deposited on a polytetrafluoroethylene (PTFE) substrate by the method of manufacturing a flexible copper clad laminated film having a polytetrafluoroethylene (PTFE) substrate according to the present invention.
FIG. 7 illustrates an x-ray diffraction experiment result image of a Cu/e-PTFE thin film manufactured using the method of manufacturing a flexible copper clad laminated film having a polytetrafluoroethylene (PTFE) substrate according to the present invention.
FIG. 8 illustrates an AFM surface image of a Cu/e-PTFE thin film manufactured using the method of manufacturing a flexible copper clad laminated film having a polytetrafluoroethylene (PTFE) substrate according to the present invention.
FIG. 9 illustrates another example of an AFM surface image of a Cu/e-PTFE thin film manufactured using the method of manufacturing a flexible copper clad laminated film having a polytetrafluoroethylene (PTFE) substrate according to the present invention.
FIG. 10 illustrates another example of an AFM surface image of a Cu/e-PTFE thin film manufactured using the method of manufacturing a flexible copper clad laminated film having a polytetrafluoroethylene (PTFE) substrate according to the present invention.
FIG. 11 illustrates an SEM image of a Cu/e-PTFE thin film manufactured using the method of manufacturing a flexible copper clad laminated film having a polytetrafluoroethylene (PTFE) substrate according to the present invention.

### [Best Modes of the Invention]

Hereinafter, exemplary embodiments of the present invention will be described in detail with reference to the accompanying drawings. However, the present disclosure is not limited to the exemplary embodiments to be described below and may be specified as other aspects. On the contrary, the embodiments introduced herein are provided to make the disclosed content thorough and complete, and sufficiently transfer the spirit of the present invention to those skilled in the art. Like reference numerals indicate like constituent elements throughout the specification.

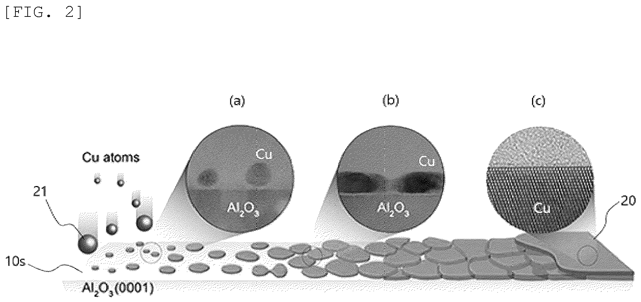

A method of manufacturing a flexible copper clad laminated film having a polytetrafluoroethylene (PTFE) substrate according to the present invention, is characterized in that an atomic sputtering epitaxy (ASE) process is used to improve the adhesion between a polytetrafluoroethylene (PTFE) substrate and a metal thin film and to uniformly deposit the metal thin film on the polytetrafluoroethylene (PTFE) substrate. With reference to FIG. 2, the atomic sputtering epitaxy (ASE) process used in the present invention will be described.

FIG. 2 illustrates an initial growth mechanism of a metal thin film 20 deposited on a sapphire (Al₂O₃) substrate 10s through an atomic sputtering epitaxy (ASE) process.

As illustrated in FIG. 2, the initial growth mechanism of the metal thin film 20 comprises three steps (a) to (c), specifically, step (a) is a step in which an ejected metal particle 21 grows into a nanodroplet shape, step (b) is a step in which the nanodroplet-shaped metal particles 21 are integrated with each other, and step (c) is a step in which the metal particles 21 grow into a plurality of layers.

In a general sputtering process, a polycrystalline metal thin film 20 is deposited on the sapphire substrate 10s so that grain boundaries are formed in the polycrystalline metal thin film 20. The grain boundary is a thin transition layer that forms an interface between grains, and the region of the grain boundary solidifies at the end of the crystal growth process to contain impurities or have oxygen atoms bonded to the region to form a copper oxide. Therefore, the general sputtering process has a problem of not allowing the copper thin film 20 to grow epitaxially on top of the sapphire substrate 10s.

Accordingly, the atomic sputtering epitaxy (ASE) process may be performed to implement a monoatomic layer-level ultra-flat copper thin film 20 on top of the sapphire substrate 10s to avoid copper oxidation.

Meanwhile, while the metal particle 21 is ejected from a target material in lumps and deposited on a surface to be deposited in the general sputtering process, the atomic sputtering epitaxy (ASE) process involves a thin film growth method in which atoms are stacked one by one on a surface to be deposited like stacking bricks. Hereinafter, the atomic sputtering epitaxy (ASE) process is described in more detail.

In general, copper (Cu) is the most widely used conductor in electrical civilization. However, a critical weakness of oxidation has limited the use of copper, leading to the use of gold, a much more expensive precious metal despite having worse electrical conductivity than copper, for ultra-precise materials or circuits that need to be highly reliable. Various studies have been conducted on copper oxidation, but they have described the phenomenological state or only reported theoretical predictions. As materials become miniaturized and highly integrated, securing sufficient usage time and miniaturization of the power unit become crucial, requiring materials with high conductivity. Under this background, the atomic sputtering epitaxy (ASE) process may be performed to solve the problem of copper oxidation on the sapphire substrate 10s.

Given that it is empirically known that oxidation proceeds from the rough parts of copper, the utmost priority should be to create a thin film with the best possible surface state. Therefore, the atomic sputtering epitaxy (ASE) process method may be used to grow a thin film having a monoatomic layer-level ultra-flat surface on the sapphire substrate 10s.

The metal thin film 20 manufactured on the sapphire substrate 10s is in a single crystal state and has an ultra-flat surface with an RMS roughness of 0.2 nm or less, and does not oxidize even when exposed to air for a long period of time. Through high-resolution transmission electron microscopy observation, when the surface of the metal thin film is maintained at a roughness of no greater than a monoatomic layer, no phase transition due to oxidation occurs. As a result of calculating the oxygen penetration energy according to the surface state through first principle calculation, when the surface is maintained with a roughness of no greater than a monoatomic layer, energy needs to be supplied from the outside for oxygen to penetrate into the metal thin film 20, and thus oxidation does not occur easily. In addition, there exists a self-regulating function that generates a repulsive force and inhibits oxidation by itself when an oxygen occupancy level of the surface on which oxygen is adsorbed physically without chemical bonding exceeds 50 %.

As described above, the effects of copper oxidation on the material industries are significant due to the use of the atomic sputtering epitaxy (ASE) process, which is applicable in many areas where the replacement of existing gold (Au) with copper is desired. In particular, with the development of nanoscience, oxidation of thin conducting wires has become a more serious problem as circuits become smaller in line width and have higher level of integration, while ultra-flat single crystal thin films do not need to be concerned about oxidation, thus having a very wide range of applications. Economically, the copper thin film may set the stage for the complete replacement of gold used in nanocircuits and the like. The electrical conductivity of copper is superior to gold by about 40 %, and when the copper is made into a single crystal copper thin film with an ultra-flat surface, the thin film may have a conductivity of 15 % or more higher than that of ordinary copper, thus providing great economic added value in reducing consumption power and energy, extending usage time, miniaturizing equipment, and the like.

Meanwhile, a technology for depositing the metal thin film 20, such as the copper thin film, on the sapphire (aluminum oxide, Al₂O₃) substrate 10s by performing the atomic sputtering epitaxy (ASE) process has been introduced, but there has not been introduced a technology for uniformly depositing the copper thin film on the polytetrafluoroethylene (PTFE) substrate 10 by applying the atomic sputtering epitaxy (ASE) process.

The polytetrafluoroethylene (PTFE) is one of the materials that has gained attention in recent years because the PTFE has good low dielectric properties while possessing sufficient mechanical properties, especially when applied as a substrate for a flexible copper clad laminated (FCCL) film, the PTFE material may reduce data loss and improve transmission speed.

However, when the copper thin film is deposited on the polytetrafluoroethylene (PTFE) substrate 10 by performing the atomic sputtering epitaxy (ASE) process, there have been difficulties in the process because the PTFE material is a polymer material that is relatively vulnerable to environmental variables such as temperature and pressure, unlike the crystalline substrate made of aluminum oxide (Al₂O₃) and the like, and thus the properties of the PTFE material easily change during the deposition process, resulting in the degraded quality of the FCCL.

In addition, when the copper thin film is deposited on the polytetrafluoroethylene (PTFE) substrate 10 by performing the atomic sputtering epitaxy (ASE) process, unlike the crystalline substrate such as the sapphire substrate 10s, there has been a problem in that the adsorption energy between the polytetrafluoroethylene (PTFE) substrate 10 and the copper thin film is insufficient, causing the copper thin film to be easily detached from the polytetrafluoroethylene (PTFE) substrate 10 and the decrease in electrical conductivity.

Accordingly, the present invention applies the atomic sputtering epitaxy (ASE) process introduced in the related art and improves deposition conditions to suit a substrate material. As a result, the uniform deposition of the metal thin film 20 even on the polytetrafluoroethylene (PTFE) substrate 10 is made easier, thereby improving the electrical performance of the flexible copper clad laminated (FCCL) film, and the adsorptivity at the interface between the polytetrafluoroethylene (PTFE) substrate 10 and the metal thin film 20 may be improved.

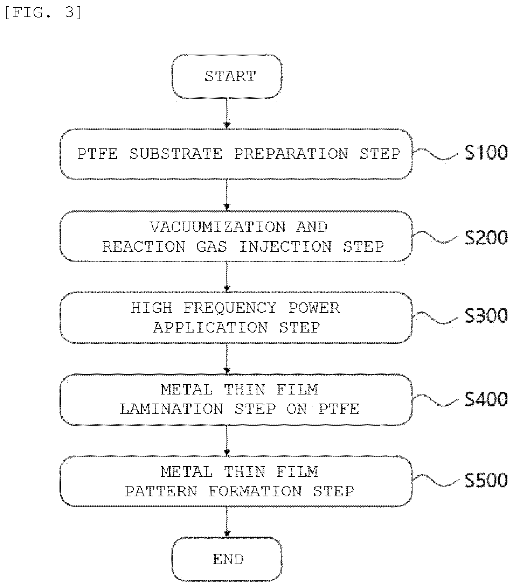

FIG. 3 is a process flowchart of a method of manufacturing a flexible copper clad laminated film having a polytetrafluoroethylene (PTFE) substrate according to the present invention.

As illustrated in FIG. 3, a method of manufacturing a flexible copper clad laminated film having a polytetrafluoroethylene (PTFE) substrate according to the present invention may include a polytetrafluoroethylene (PTFE) substrate preparation step S100 in which a substrate made of a polytetrafluoroethylene (PTFE) material is prepared in a chamber space of a vacuum chamber, a reaction gas injection step S200 in which a reaction gas is injected after the chamber space of the vacuum chamber is formed with a vacuum for a sputtering process, a high frequency power application step S300 in which high frequency power is applied to a target mounted on an inner upper end of the vacuum chamber and made of single crystal metal particles, and a metal thin film lamination step S400 in which metal particles separated from the target by the applied high frequency power are deposited on top of the polytetrafluoroethylene (PTFE) substrate 10, and thus a metal thin film 20 is laminated.

In manufacturing the flexible copper clad laminated (FCCL) film, the present invention provides a method of manufacturing a PTFE-based flexible copper clad laminated substrate in which a high-quality metal thin film 20 may be controlled by applying the atomic sputtering epitaxy (ASE) process to control the crystal structure of the metal thin film 20 on the polytetrafluoroethylene (PTFE) substrate 10 constituting the flexible copper clad laminated (FCCL) film by atomic layer units.

A sputtering apparatus used in the method of manufacturing a PTFE-based flexible copper clad laminated substrate according to the present invention, illustrated in FIG. 3, is a device in which noise, electrical noise, and dynamic noise of a target material are removed from a general sputtering apparatus, and may perform the atomic sputtering epitaxy (ASE) process described above.

The method of manufacturing a PTFE-based flexible copper clad laminated substrate according to the present invention may be performed by a sputtering apparatus including a vacuum chamber, an RF generating unit, a vacuum pump unit, a gas supply unit, and a vibration isolation unit.

First, the polytetrafluoroethylene (PTFE) substrate preparation step S100 of preparing a substrate made of a polytetrafluoroethylene (PTFE) material in a chamber space of a vacuum chamber may be performed.

Here, the vacuum chamber is a space in which a sputtering process of depositing the metal thin film 20 on the polytetrafluoroethylene (PTFE) substrate 10 is performed, and the vacuum chamber comprises a polytetrafluoroethylene (PTFE) substrate, a target, and a chamber space. The polytetrafluoroethylene (PTFE) substrate 10 is an anode portion of the sputtering process, and may be made of a polytetrafluoroethylene (PTFE) material. A target is positioned on a cathode portion facing the polytetrafluoroethylene (PTFE) substrate 10, and the target is formed of a metal material of a thin film to be deposited on the polytetrafluoroethylene (PTFE) substrate 10. The polytetrafluoroethylene (PTFE) substrate 10 and the target as described above are positioned inside the chamber space, such that the particles falling off the target are separated by a subsequent sputtering process and deposited on the polytetrafluoroethylene (PTFE) substrate 10 to manufacture the metal thin film 20.

In the polytetrafluoroethylene (PTFE) substrate preparation step S100, the temperature of the chamber space of the vacuum chamber in which the polytetrafluoroethylene (PTFE) substrate 10 is prepared may be formed and maintained in a range of 140 °C to 200 °C, preferably in a range of 150 °C to 170 °C. There is a problem in that when the temperature inside the chamber space is less than 140 °C, the metal thin film 20 deposited on the polytetrafluoroethylene (PTFE) substrate 10 is not uniformly formed, while when the temperature is greater than 200 °C, the polytetrafluoroethylene (PTFE) substrate 10 changes its properties.

In addition, for the method of manufacturing a PTFE-based flexible copper clad laminated substrate according to the present invention, the pressure condition or vacuum condition inside the chamber space may be optimized through repeated experiments so that the crystals of the metal thin film 20 are able to grow uniformly on the polytetrafluoroethylene (PTFE) substrate 10. Further, the polytetrafluoroethylene (PTFE) substrate 10 may be pretreated so that the metal thin film 20 may grow with high adsorptivity at the interface of the polytetrafluoroethylene (PTFE) substrate 10.

Next, the reaction gas injection step S200 and the high frequency power application step S300 of the present invention may be performed sequentially.

The reaction gas injection step S200 is a step in which the reaction gas is injected after the chamber space of the vacuum chamber is formed into a vacuum for the sputtering process, and the high frequency power application step S300 is a step in which the high frequency power is applied to a target mounted on an inner upper portion of the vacuum chamber and made of single crystal metal particles.

The reaction gas injection step S200 and the high frequency power application step S300 may be performed by the gas supply unit and the RF generating unit constituting the sputtering apparatus, respectively.

The RF generating unit for performing the high frequency power application step S300 is configured to apply RF power, which is high frequency power, to a target in the vacuum chamber for the sputtering process, and is connected to the target by a connecting conductive wire.

Meanwhile, the chamber space is required to be formed in a vacuum state for the sputtering process, and the vacuum pump unit constituting the sputtering apparatus is configured to suction a fluid inside the chamber space such that the chamber space of the vacuum chamber is formed in a vacuum, and may be a commonly used rotary pump.

To this end, the gas supply unit that supplies the reaction gas for the sputtering process is connected to the chamber space of the vacuum chamber in a vacuum state, and the reaction gas supplied by the gas supply unit may be argon (Ar) gas, and the higher the purity of the argon gas, the more homogeneously the deposited particles are separate from the target on the entire surface of the target, so that the metal thin film lamination step S400 may be performed.

In the metal thin film lamination step S400, with the configuration of the sputtering apparatus described above, when RF power is applied through the RF generating unit to the target in the chamber space supplied with the reaction gas in a vacuum state, the reaction gas is ionized by a glow discharge, and a plasma discharge is generated between the polytetrafluoroethylene (PTFE) substrate 10 and the target. In this case, the positive ions present in a discharge area strike the surface of the target by electrical power, and the deposition particles that have fallen off the surface of the target are deposited on the polytetrafluoroethylene (PTFE) substrate 10 facing each other, and thus the metal thin film 20 is manufactured.

Meanwhile, in performing the high frequency power application step S300 of the present invention, a power cable supplying power to the RF generating unit is formed from a single crystal copper wire, through which the signal transmitted to the power cable is not mixed with noise and signal distortion, the stability of the RF power applied to the target increases, and the deposition particles may fall off homogeneously from the entire surface of the target, thereby improving the quality of the metal thin film 20 deposited on the polytetrafluoroethylene (PTFE) substrate 10.

Further, the homogeneity of the deposition particles falling off the target is associated with the crystallinity of the target, in that the deposition particles are separated from the target. Therefore, the target included in the vacuum chamber may be formed of a single crystal metal. As described above, when the target is formed of a single crystal metal, metal particles are formed evenly with a certain orientation on the entire surface of the target, and the deposition particles separated from the target are also homogeneous, so that the metal thin film 20 to be deposited may be manufactured with high quality. A type of single crystal metal forming the target is determined by a type of the metal thin film 20 desired to be deposited on the polytetrafluoroethylene (PTFE) substrate 10, and may be copper, silver, or a single elemental metal.

In addition, the connecting conductive wire for transmitting the RF power of the RF generating unit to the target of the vacuum chamber when performing the high frequency power authorization step S300 may also be formed of a single crystal copper wire. Accordingly, the electrical noise in the RF power applied to the target may be eliminated and the stability of the power may increase, and the homogeneity of the plasma discharge formed between the polytetrafluoroethylene (PTFE) substrate 10 and the target may increase, resulting in a homogeneous fall of the deposition particles off the entire surface of the target.

An outdoor grounding portion formed for grounding the RF generating unit may be formed of a single crystal copper bulk. The single crystal copper constituting the outdoor grounding portion may be manufactured with the target, when the metal type of the target is copper. As described above, when the outdoor grounding portion is formed from a single crystal copper bulk, the stability of the RF power may increase, resulting in a homogeneous fall of the deposition particles.

In addition, in the present invention, the dynamic noise, e.g., vibration, is prevented from being applied during the deposition of the deposition particles falling off the target onto the polytetrafluoroethylene (PTFE) substrate 10 in the metal thin film deposition step S400, so that the metal thin film 20 may be grown to have a high adsorptivity at the interface with the PTFE thin film.

To this end, the vacuum chamber may have each corner of the bottom surface supported by a vibration isolation unit to prevent the transmission of vibrations from the floor. The vibration isolation unit has a dynamically irreversible structure that does not transmit floor vibrations into the vacuum chamber, but rather offsets the vibrations generated in the vacuum chamber by discharging the vibrations to the outside (floor) .

Specifically, the vibration isolation unit for isolating the vibrations transmitted to the vacuum chamber in the metal thin film lamination step S400 comprises a spike and a mat for damping. The spike is constituted of being attached to the bottom surface of the vacuum chamber to support the vacuum chamber and has a sharp horn shape toward the floor. The mat for damping is constituted of being rested on the floor and receiving a spike on an upper surface thereof, an insertion groove is formed in the upper surface of the mat for damping in which a peak of the spike is received, and the spike being received in the insertion groove of the mat for damping causes the planar position of the spike to be fixed.

The vibrations generated from the floor may only shake the mat for damping, but not apply a force to the spike, and thus not be transmitted to the vacuum chamber supported by the spike. As a result, the vacuum chamber is not affected by the vibration of the floor, no physical external force is applied during the deposition of the deposition particles separated from the target onto the polytetrafluoroethylene (PTFE) substrate 10, and the metal thin film 20 may be deposited homogeneously on the polytetrafluoroethylene (PTFE) substrate 10 to improve the quality. Meanwhile, the spike may be formed in a variety of shapes, such as a cone, a triangular pyramid, and a square pyramid, where a horn shape is sufficient.

Further, to further isolate the vacuum chamber from physical vibrations, the sputtering apparatus used for the method of manufacturing a PTFE-based flexible copper clad laminated substrate of the present invention may physically separate the vacuum chamber and the vacuum pump unit.

The rotary pump, which is an example of the vacuum pump unit, generates a lot of vibrations in the process of suctioning fluid to make the chamber space of the vacuum chamber vacuum, and when the vacuum chamber and the vacuum pump unit are physically constituted together, the vibrations generated in the process of operation of the vacuum pump unit is transmitted to the vacuum chamber, and the deposition particles deposited on the polytetrafluoroethylene (PTFE) substrate 10 are not formed evenly.

Therefore, the vacuum pump unit is physically separated from the vacuum chamber, and the connection to the chamber space is provided by a pump line made of a rubber material, and in order to isolate even the vibrations of the pump line from being transmitted to the vacuum chamber, a center of the pump line may be fixed on a wall surface connecting to the floor.

Meanwhile, when the vacuum pump unit is physically separated from the vacuum chamber, the vacuum pump unit itself also needs to be isolated from vibrations, and in this case, each corner of the bottom surface thereof may be supported by a vibration isolation unit to prevent the transmission of vibration from the floor as in the vacuum chamber.

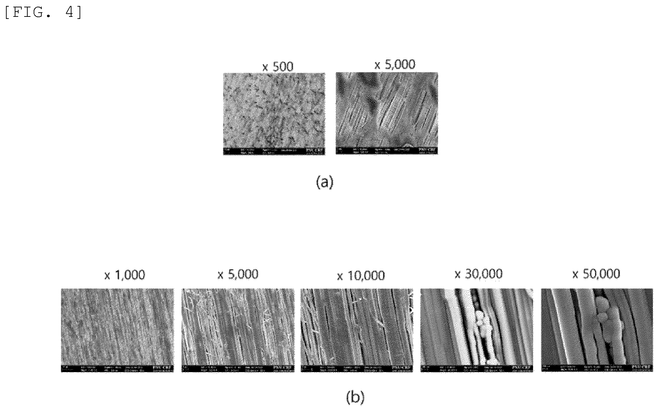

FIG. 4A is an image observed using a scanning electron microscope (SEM) of a pure polytetrafluoroethylene (PTFE) substrate with no copper deposited, and FIG. 4B is an image observed using a SEM of a polytetrafluoroethylene (PTFE) substrate with copper deposited.

Meanwhile, as illustrated in FIG. 4A, it is not easy to observe the surface of the polytetrafluoroethylene (PTFE) substrate 10 using a scanning electron microscope (SEM) due to the charging of electrons, but it is confirmed that the surface of the polytetrafluoroethylene (PTFE) substrate 10 appears rough and bumpy when observed under magnification of 500x and 5000x. As illustrated in FIG. 4B, it can be seen that when a copper thin film is deposited to a thickness of 200 nm on the polytetrafluoroethylene (PTFE) substrate 10 using the sputtering apparatus described above by the atomic sputtering epitaxy (ASE) process, the film is deposited very evenly while retaining the shape of the original PTFE.

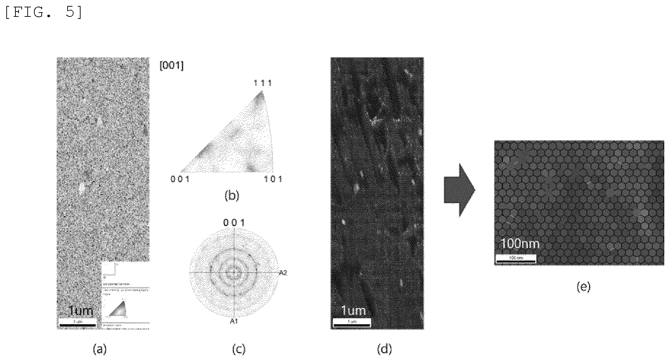

FIG. 5 is an image of a copper surface deposited on the PTFE observed using electron beam scatter diffraction (EBSD).

As illustrated in FIG. 5, when the map of a 200 nm thick copper surface deposited on the PTFE using electron beam scatter diffraction (EBSD) is observed, it can be seen that all the copper grains are arranged in different orientations.

FIG. 5B and FIG. 5C illustrate the inverse pole figure (IPF) and pole figure (PF) as surface points of the grain measured from different axial directions of the crystal, respectively, and it can be seen that the crystal orientations are scattered in very diverse orientations.

FIG. 5D illustrates an IQ image of a misorientation map indicating the boundary lines between grains, which appear only in very blue color, with no misorientation lines visible at all. Here, the red color represents lines that are exactly satisfied with a twin boundary condition, and the blue color represents grain boundaries in any direction that are not satisfied with a specific condition. Almost no red color lines, only blue, means that the grains are scattered in very diverse directions.

When the image illustrated in FIG. 5D is enlarged, the grains are seen as in FIG. 5E (scale bar:100 nm), and it can be observed that the size of the grains is very uniform and densely disposed throughout, with the maximum size of the grains corresponding to about 10 nm. This small grain size minimizes the spacing of atoms at the grain boundaries and ensures that gaps are minimized, which, despite being polycrystalline, leaves less space for oxygen or foreign impurities to enter, minimizing the progress of oxidation and preventing the formation of copper oxide.

In the method of manufacturing a flexible copper clad laminated film having a polytetrafluoroethylene (PTFE) substrate according to the present invention, a metal thin film pattern formation step S500 may be further performed in which a pattern p having a specific shape is formed on a surface of the metal thin film 20 laminated on the polytetrafluoroethylene (PTFE) substrate 10.

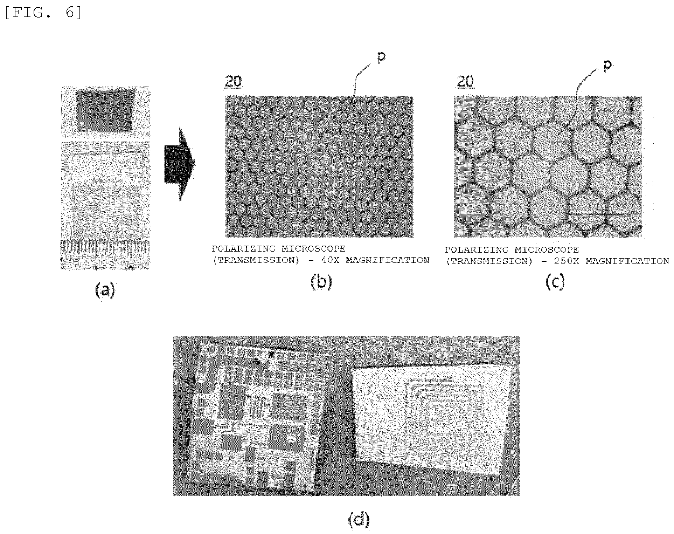

FIG. 6 is a photographing image of a mesh and a circuit patterned from a copper thin film deposited on a polytetrafluoroethylene (PTFE) substrate by the method of manufacturing a flexible copper clad laminated film having a polytetrafluoroethylene (PTFE) substrate according to the present invention.

FIG. 6B and FIG. 6C illustrate enlarged images of a hexagonal honeycomb mesh patterned from a copper thin film deposited on the polytetrafluoroethylene (PTFE) substrate 10 through a photolithography process using the method of manufacturing a flexible copper clad laminated film having a polytetrafluoroethylene (PTFE) substrate according to the present invention. The images illustrated in FIG. 6B and FIG. 6C were taken at 40x and 250x magnifications, respectively, using a transmission polarizing microscope.

FIG. 6D illustrates a circuit image patterned from a copper thin film deposited on the polytetrafluoroethylene (PTFE) substrate 10 using the method of manufacturing a flexible copper clad laminated film having a polytetrafluoroethylene (PTFE) substrate according to the present invention, through a photolithography process.

As illustrated in FIG. 6A, a hexagonal honeycomb mesh pattern p may be formed on the copper thin film deposited on the e-polytetrafluoroethylene (PTFE) substrate. The mesh pattern p may perform an electrical connection using a copper thin film in a product such as an electronic device or a solar cell, and the surface of the copper thin film may be strengthened to increase durability. The mesh pattern p may be formed by a method of making holes in the surface of the copper thin film at predetermined intervals and connecting copper wires therein.

A linewidth of the mesh pattern p formed through the metal thin film pattern formation step S500 is determined by the interval between the holes made in the copper thin film, and as the linewidth decreases, the electrical resistance decreases. An open area of the mesh pattern means an area ratio taken up by the holes in the mesh pattern, and as the open area is greater, the current flows easily, which may allow the electrical connection to be made effectively.

The linewidth and open area of the mesh pattern p may be suitably selected depending on the electrical performance and manufacturing cost required for the flexible copper clad laminated (FCCL) film and the like. In the example illustrated in FIG. 6A, it is confirmed that the mesh pattern p of the copper thin film deposited on the e-polytetrafluoroethylene (PTFE) substrate has a linewidth of about 10 µm and an open area of about 50 µm.

The mesh pattern of the copper thin film is one of the types of printed circuit boards (PCBs) used in an electronic circuit, and the polytetrafluoroethylene (PTFE) substrate 10 on which the copper thin film is deposited for electrical connections may be used to form a desired circuit pattern as illustrated in FIG. 6B.

As described above, in the method of manufacturing a flexible copper clad laminated film having a polytetrafluoroethylene (PTFE) substrate according to the present invention, environmental variables during the sputtering process, for example, process variables such as temperature, pressure, and vacuum degree inside the chamber space are controlled, deposition conditions optimized for the polytetrafluoroethylene (PTFE) substrate 10 are specified, and a pretreatment process of the polytetrafluoroethylene (PTFE) substrate 10 is performed. Accordingly, it was confirmed that the metal thin film 20 may be uniformly deposited by performing the atomic sputtering epitaxy (ASE) process on the polytetrafluoroethylene (PTFE) substrate 10 rather than on an existing crystalline substrate.

Specifically, as a result of performing the atomic sputtering epitaxy (ASE) process as the method of manufacturing a flexible copper clad laminated film having a polytetrafluoroethylene (PTFE) substrate according to the present invention, it was confirmed that the crystal growth rate of the copper thin film is about 10 nm/min or more, the grain size is very uniform at a level of 10 to 15 nm, the vacancy or stacking defects caused by grain boundaries are minimized, and the surface roughness is at a level of about 0.5 nm.

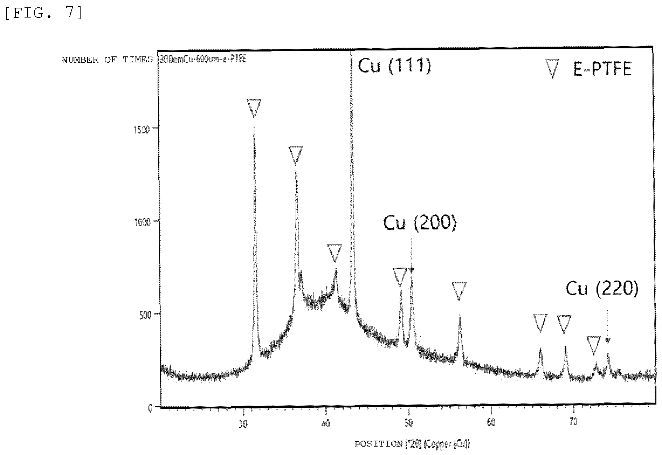

FIG. 7 illustrates an x-ray diffraction experiment result image of a Cu/e-PTFE thin film with 300 nm of Cu deposited using the method of manufacturing a flexible copper clad laminated film having a polytetrafluoroethylene (PTFE) substrate according to the present invention.

As illustrated in FIG. 7, there is a plurality of e-PTFE diffraction peaks 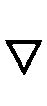 diffraction peaks of copper in the x-ray diffraction experiment result image of the Cu/e-PTFE thin film. In addition, it can be seen that there are diffraction picks in multiple directions in the image above, and both materials (e-PTFE and Cu) exist in a polycrystalline state. Meanwhile, it was confirmed that the grains corresponding to (100) and (110) orientations are also present, but mainly the Cu (111) orientation is the most well developed.

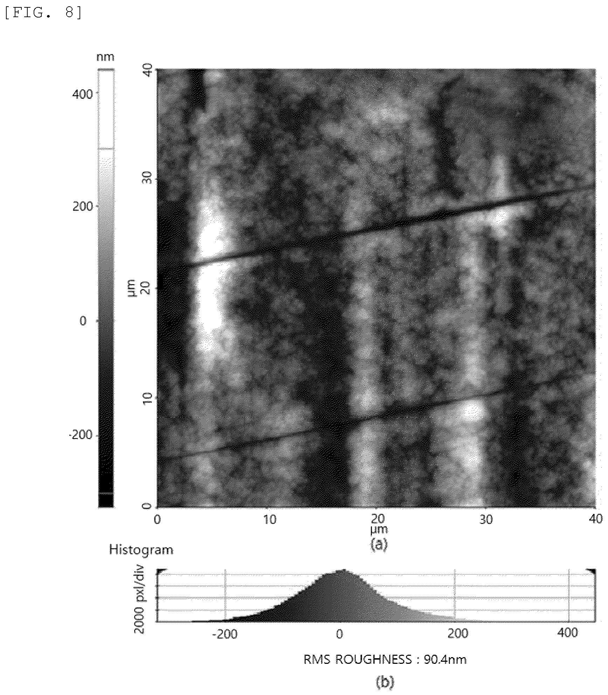

FIG. 8 illustrates an AFM surface image of a Cu/e-PTFE thin film manufactured using the method of manufacturing a flexible copper clad laminated film having a polytetrafluoroethylene (PTFE) substrate according to the present invention. It was confirmed from the AFM surface image of the Cu/e-PTFE thin film illustrated in FIG. 8 that the RMS roughness is at a level of about 90.4 nm.

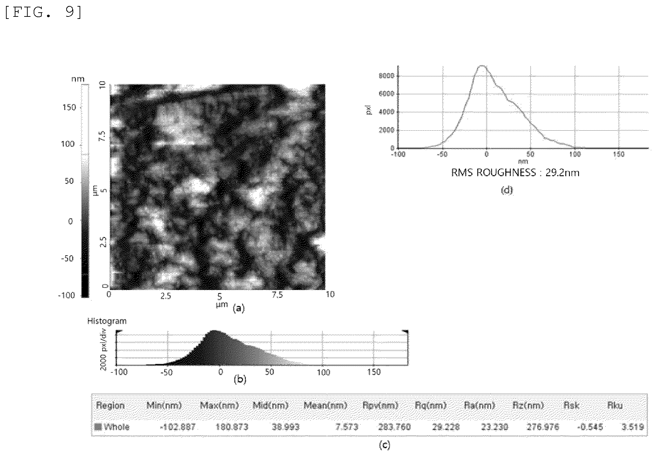

FIG. 9 illustrates another example of an AFM surface image of a Cu/e-PTFE thin film manufactured using the method of manufacturing a flexible copper clad laminated film having a polytetrafluoroethylene (PTFE) substrate according to the present invention.

Specifically, the AFM surface image of the Cu/e-PTFE thin film illustrated in FIG. 9 is the result of reducing the measurement range in FIG. 8 to 10 µm² (10 µm X 10 µm). It was confirmed that the RMS roughness was reduced to a level of about 29.2 nm when the defect portion of the e-PTFE is excluded in the AFM surface image of the Cu/e-PTFE thin film illustrated in FIG. 9.

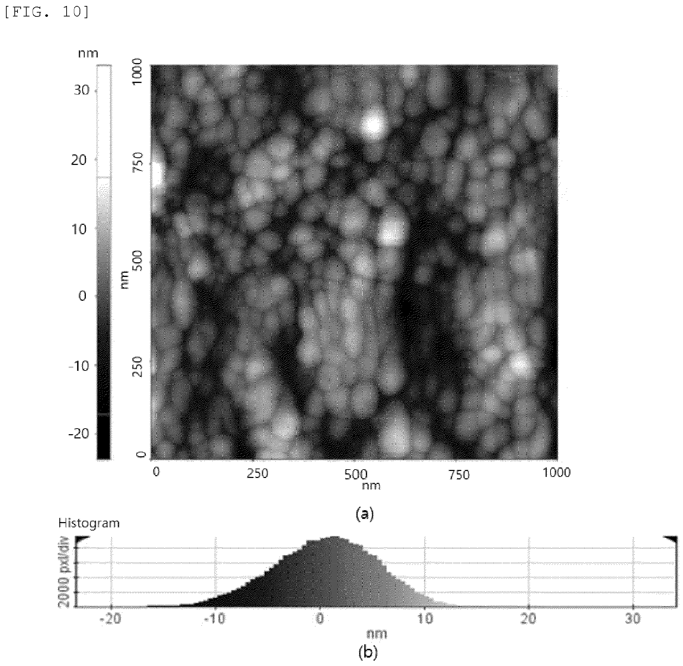

FIG. 10 illustrates another example of an AFM surface image of a Cu/e-PTFE thin film manufactured using the method of manufacturing a flexible copper clad laminated film having a polytetrafluoroethylene (PTFE) substrate according to the present invention.

Specifically, the AFM surface image of the Cu/e-PTFE thin film illustrated in FIG. 10 is the result of reducing the measurement range in FIG. 8 to 1 µm² (1 µm X 1 µm). It was confirmed that the RMS roughness was reduced to a level of about 5 nm in the AFM surface image of the Cu/e-PTFE thin film illustrated in FIG. 10, due to the removal of most of the defect portions of the e-PTFE. In addition, it was confirmed that copper (Cu) particles were present in the form of fine grains in the copper thin film deposited on the e-polytetrafluoroethylene (PTFE) substrate.

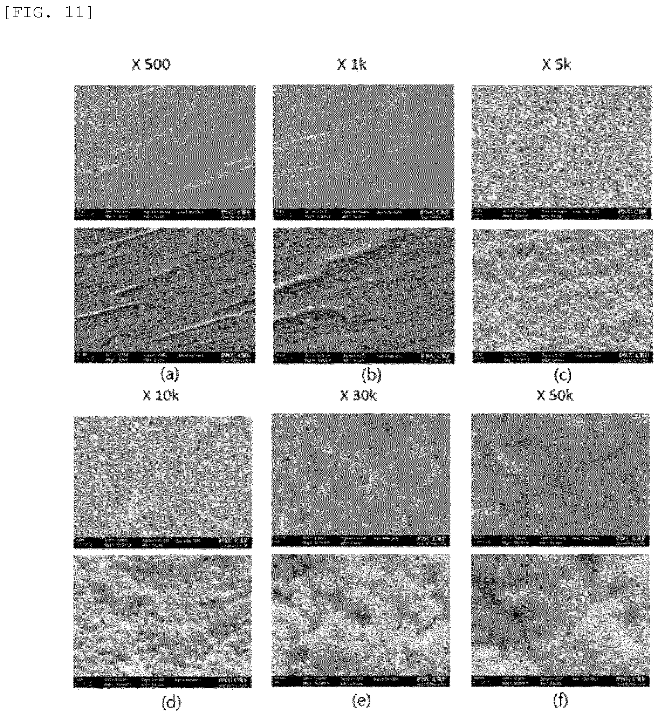

FIG. 11 illustrates an SEM image at various magnifications of the Cu/e-PTFE thin film with 300 nm of Cu deposited using the method of manufacturing a flexible copper clad laminated film having a polytetrafluoroethylene (PTFE) substrate according to the present invention.

The state of the e-polytetrafluoroethylene (PTFE) substrate can be seen in the SEM image of the Cu/e-PTFE thin film at low magnification, while the morphology of the deposited copper can be observed in the SEM image of the Cu/e-PTFE thin film at high magnification, and it can be seen that the copper (Cu) particles are present in the form of grains, as observed in FIG. 10.

The method of manufacturing a flexible copper clad laminated film having a polytetrafluoroethylene (PTFE) substrate according to the present invention may implement excellent high temperature oxidation resistance properties when the polytetrafluoroethylene (PTFE) substrate 10 on which the metal thin film 20 is deposited by applying the atomic sputtering epitaxy (ASE) process is used in a semiconductor PCB. Therefore, there is an effect in the semiconductor industry that can solve the problem of circuit performance degradation caused by server heat in ICT.

In addition, the method of manufacturing a flexible copper clad laminated film having a polytetrafluoroethylene (PTFE) substrate according to the present invention can apply the atomic sputtering epitaxy (ASE) process to evenly control the copper oxide layer on the polytetrafluoroethylene (PTFE) substrate 10. In the existing manufacturing method, since the polycrystalline metal thin film 20 is formed on the substrate, oxygen atoms are adsorbed on the grain boundaries inside the metal thin film 20, resulting in an irregular oxidation process. In contrast, the metal thin film 20 deposited on the polytetrafluoroethylene (PTFE) substrate 10 by the method of manufacturing a flexible copper clad laminated film using the polytetrafluoroethylene (PTFE) substrate 10 according to the present invention is a flat and dense thin film, so that oxidation can proceed evenly on the surface, and thus a material capable of securing reliable 5G communication quality can be implemented. In the existing communication industry, a copper oxide layer is formed due to the content of moisture in the atmosphere (rain, resonance absorption of oxygen or water molecules in the air), resulting in communication quality degradation and attenuation issues, but the method of manufacturing a flexible copper clad laminated film having a polytetrafluoroethylene (PTFE) substrate according to the present invention can control the copper oxide layer in the copper thin film on the polytetrafluoroethylene (PTFE) substrate 10, so that communication quality reliability can be secured in a high frequency environment.

Further, when a graphene thin film is grown on the copper thin film deposited on the polytetrafluoroethylene (PTFE) substrate using the atomic sputtering epitaxy (ASE) process in accordance with the method of manufacturing a flexible copper clad laminated film having a polytetrafluoroethylene (PTFE) substrate according to the present invention, the copper thin film has an extremely strong thermal conductivity and can be used as a heat dissipation material for various electronic components such as an OLED.

While the present invention has been described above with reference to the exemplary embodiments, it may be understood by those skilled in the art that the present invention may be variously modified and changed without departing from the spirit and scope of the present invention disclosed in the claims. Therefore, it should be understood that any modified embodiment that essentially includes the constituent elements of the claims of the present invention is included in the technical scope of the present invention.

## Claims

1. A method of manufacturing a PTFE-based flexible copper clad laminated substrate, the method comprising:
a polytetrafluoroethylene (PTFE) substrate preparation step, wherein a substrate made of a polytetrafluoroethylene (PTFE) material is prepared in a chamber space of a vacuum chamber;
a reaction gas injection step, wherein a reaction gas is injected after the chamber space of the vacuum chamber is formed with a vacuum for a sputtering process;
a high frequency power application step, wherein high frequency power is applied to a target mounted on an inner upper portion of the vacuum chamber and made of single crystal metal particles; and
a metal thin film lamination step, wherein metal particles separated from the target by the applied high frequency power are deposited on top of the polytetrafluoroethylene (PTFE) substrate to form a metal thin film.

2. The method of claim 1, wherein in the polytetrafluoroethylene (PTFE) substrate preparation step, the chamber space of the vacuum chamber in which the polytetrafluoroethylene (PTFE) substrate is prepared is formed to have a temperature in a range of 140 °C to 200 °C.

3. The method of claim 1, wherein in the reaction gas injection step, the gas injected into the chamber space of the vacuum chamber includes argon (Ar).

4. The method of claim 1, wherein in the high frequency power application step, the high frequency power is transmitted to the target mounted on an inner upper end of the vacuum chamber through a power supply line constituted of a single crystal copper wire.

5. The method of claim 1, wherein in the metal thin film lamination step, the metal thin film is deposited on the top of the polytetrafluoroethylene (PTFE) substrate through an atomic sputtering epitaxy (ASE) process in which metal particles of atomic units are deposited on the top of the polytetrafluoroethylene (PTFE) substrate.

6. The method of claim 1, wherein in the metal thin film lamination step, the metal thin film is laminated on the top of the polytetrafluoroethylene (PTFE) substrate with a thickness in a range of 100 to 300 nm.

7. The method of claim 1, wherein in the metal thin film lamination step, the metal particles include copper (Cu).

8. The method of claim 1, wherein in the metal thin film lamination step, vibrations transmitted to the vacuum chamber are absorbed or blocked while the metal particles separated from the target are deposited on the top of the polytetrafluoroethylene (PTFE) substrate.

9. The method of claim 1, further comprising:
a metal thin film pattern formation step, wherein a pattern having a specific shape is formed on a surface of the metal thin film that has been completed to be laminated on the top of the polytetrafluoroethylene (PTFE) substrate.

10. The method of claim 9, wherein the pattern formed in the metal thin film pattern formation step has a hexagonal honeycomb shape with a linewidth of 5 µm to 14 µm.
